# EUROPEAN PATENT APPLICATION

(11) **EP 4 685 802 A1**
(43) Date of publication of application: **28.01.2026**
(21) Application number: 25190149.2
(22) Date of filing: 17.07.2025
(51) Int. Cl.: G11C 29/44

(54) **MEMORY BUILT-IN-SELF-TEST (MBIST) WITH ENHANCED FAULT COUNTER**

(30) Priority: 22.07.2024 US 202418779378
(71) Applicant: NXP USA, Inc., Austin, TX 78735 (US)
(72) Inventor: Spruth, Henning Fritz, 5656AG Eindhoven (NL); Qureshi, Qadeer, 5656AG Eindhoven (NL); He, Chen, 5656AG Eindhoven (NL); Thota, Kiran K., 5656AG Eindhoven (NL); Yanez, Jesse, 5656AG Eindhoven (NL)
(74) Representative: Miles, John Richard

(57) **Abstract**

An integrated circuit includes a memory having an array and a memory built-in self test (MBIST) controller. The MBIST controller is configured to perform memory testing rungs on the memory and includes a first counter and a repair control circuit. The first counter is configured to count uncorrectable errors during each memory testing run. The repair control circuit is configured to, in response to an error found during a memory testing run, determine whether at least one of row repair or column repair can be applied to repair the error.

## Description

### Background

### Field

This disclosure relates generally to memories, and more specifically, to memory built-in-self-test (MBIST) with an enhanced fault counter.

### Related Art

Memory compilers typically support both row and column repair in which a row or column that contains defective bit cells can be replaced with a row or column from a set of redundant rows or redundant columns of the memory, respectively, du ring production test. However, current MBIST control units do not provide sufficient diagnostic visibility when memory fails are detected during production test in such memories which include either row or column repair. This can result in over repair, i.e., repairing parts which should not be repaired due to reliability risk, which may lead to potential latent failures which may appear over time after shipping to customers. Therefore, a need exists for improved collection of additional information regarding detected failures without extensively impacting the size and complexity of the MBIST circuitry.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in block diagram form, a system-on-a-chip (SoC) having a memory built-in-self-test (MBIST) controller and one or more memories, in accordance with an embodiment of the present invention.
FIG. 2 illustrates, in flow diagram form, a production test flow which may be performed using the SoC of FIG. 1, in accordance with an embodiment of the present invention.
FIGs. 3 -6 illustrate, in diagrammatic form, a physical bit cell topology and corresponding logic memory view of a memory of the SoC of FIG. 1, in accordance with various examples of the present invention.

### Detailed Description

In memories which implement row repair, a memory may include a set of redundant rows which may be used to repair faulty rows. In such systems, it may be beneficial to differentiate between isolated single bit faults versus clustered failures like partial or full row failures. Although all of these scenarios may be repaired using row repair, row repair to replace partial or full row failures may be less reliable because a memory with such failures may be prone to additional failures on adjacent bits over time as silicon ages. Based on the physical topology of a memory, the same issue between isolated single bit faults versus clustered failures may also apply to column repairs. Therefore, in one aspect, an uncorrectable error count is used by an MBIST controller in combination with the application of row or column repair during production testing. The uncorrectable error count corresponds to a count of multi-bit errors. In one embodiment, the uncorrectable error count is used during production testing to provide additional visibility into the row and column faults which allows for improved decisions to be made as to whether or not to repair a memory or discard it. For example, if the uncorrectable error count is beyond an acceptable margin, a decision may be made to toss the memory rather than repair it, even though a particular set of faults may be considered repairable by row or column repair.

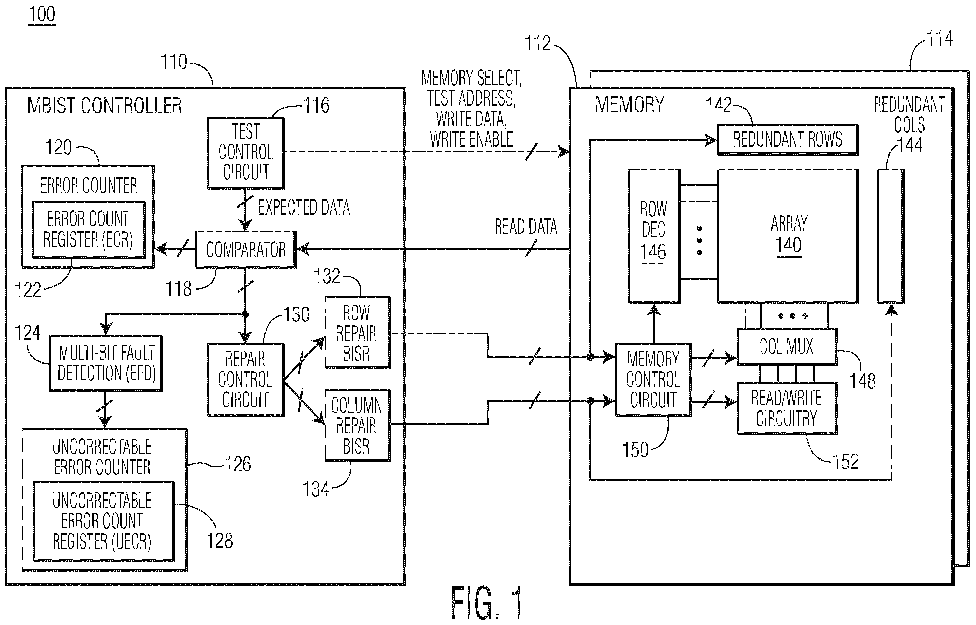

FIG. 1 illustrates, in block diagram form, an SoC 100, in accordance with an embodiment of the present invention, in which SoC 100 includes one or more memories (e.g. memory 112, 114) and a BIST controller 110 coupled to the one or more memories, in accordance with one embodiment of the present invention. MBIST controller 110 is coupled to each of the one or more memories (memory 112 and memory 114). In alternate embodiments, only memory 112 may be present or additional memories may be coupled to MBIST controller 110 in addition to memories 112 and 114. Each memory may be, for example, any type of random access memory (RAM), such as, e.g., a static random access memory (RAM), and may therefore instead be referred to herein as RAMs 112 and 114. (Although in alternate embodiments, each of the memories may be different types of memories.) SoC 100 may also include additional elements, such as, for example, any type of processing unit (e.g. CPUs, graphical processing unit (GPU), image processing unit, etc.), and may include any other type of circuitry, peripheral, input/output module, etc.

In one embodiment, SoC 100 may be implemented with any number (one or more) of subsystems, in which each subsystem may include one or more MBIST controllers, each MBIST controller coupled to one or more memories. However, for ease of explanation, descriptions herein will be focused on MBIST controller 110 and RAM 112 of SoC 100, in which the descriptions would also apply to any MBIST controller and corresponding memory of SoC 100, in any subsystem of SoC 100.

Referring to the illustrated embodiment of FIG. 1, MBIST controller 110 operates to control memory testing in a corresponding one or more RAMs. For example, MBIST controller 110 operates to control memory testing in each of RAM 112 and RAM 114, in which FIG. 1 illustrates the details of RAM 112 (in which the same details and descriptions apply to RAM 114 or any other RAM or memory coupled to and tested by MBIST controller 110). RAM 112 includes a memory array 140, a row decoder 146, a column multiplexer (MUX) 148, read/write circuitry 152, redundant rows 142, redundant columns (cols) 144, and a memory control circuit 150. Memory control circuit is coupled to MBIST controller 110, and to each of row decoder 146, column MUX 148, read/write circuitry 152, redundant rows 142, and redundant cols 144.

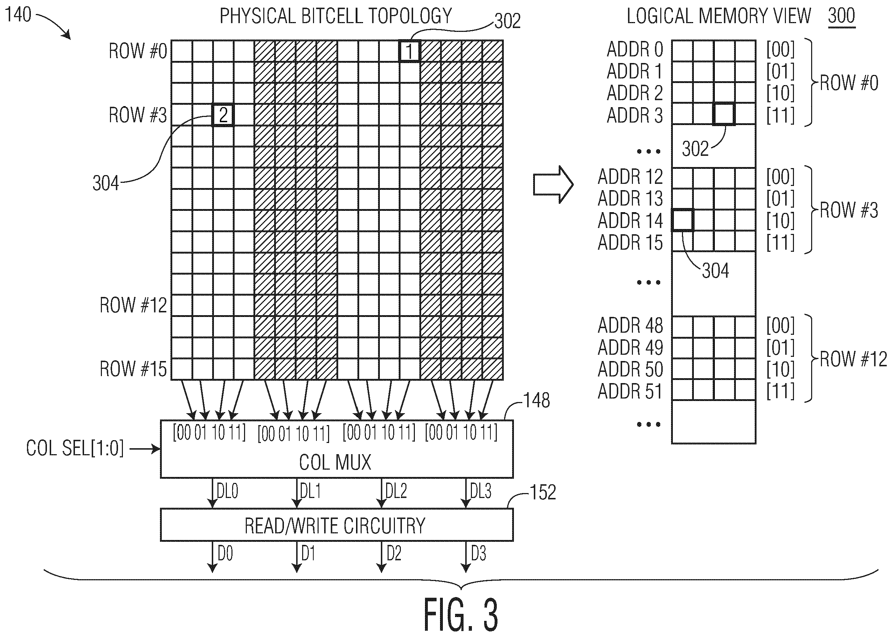

In one embodiment, array 140 includes a plurality of bit cells arranged in rows and columns, in which each row corresponds to a word line and each column corresponds to a bit line, and the bit cells of array 140 are configured to store addressable n-bit data elements (in which n can represent any integer greater than one). The addressable n-bit data elements can be, for example, 4-bit nibbles, 8-bit bytes, 16- or 32-bit words, 32- or 64-bit double-words, etc. Memory control circuit 150 receives access requests to array 140, each including an access address, in which each access request may be a read or write access request. For each access request, row decoder 146 uses a first portion of the access address to activate a selected word line for a particular row of array 140, and a second portion of the access address is used to couple a set of selected bit lines to read/write circuitry 152, via col MUX 148, to access selected bit cells located at the intersections of the selected word line and the set of selected bit lines. An example of col MUX 148 will be described in reference to FIG. 3 below. For a read access request, sense amplifiers in read/write circuitry 152 sense the logic state stored in the selected bit cells and outputs the corresponding read data. For a write access request, read/write circuitry 152 receives write data and stores the received write data into the selected bit cells. Note that operation and configuration of array 140, row decoder 146, col MUX 148, and read/write circuitry 152 are known in the art, and will therefore not be described in more detail herein. As will be described in reference to FIG. 3, if column multiplexing is not used in array 140, col MUX 148 may not be present within RAM 112 in which all bit lines of array 140 would be coupled directly to read/write circuitry 152 instead.

During normal operation (also referred to as functional operation or in-field operation), memory control circuit 150 receives access requests from a requesting device of SoC 100 (e.g. a processing unit or central processing unit), in which the requesting device provides the access address for the read and write access requests. For write requests, the requesting device also provides the corresponding write data, and for read requests, the read data is returned to the requesting device. Note that the memory including memory control circuit 150 (e.g. RAM 112) may be referred to as a target device of SoC 100. As will be described below, during memory testing by MBIST controller 110, the access addresses and write data are instead provided by MBIST controller 110 to memory control circuit 150 , and the read data is returned to MBIST controller 110.

In one embodiment, during normal operation, the data elements are stored with their corresponding Error Correcting Code (ECC) parity bits within array 140, and memory control circuit 150 further includes ECC logic to implement ECC during normal in-field operation. Therefore, in one embodiment, each read access during normal operation is used to obtain the read data as well as the corresponding ECC parity bits, and each write access stores both write data and the corresponding ECC parity bits. (Alternatively, the ECC parity bits can be stored together in a separate section of array 140 or in a memory section separate from array 140.) In one embodiment, ECC is used to implement single bit error correction and multi-bit error detection. With single bit error correction and multi-bit error detection, only single bit errors in a corresponding data element can be corrected, while multi-bit errors in the corresponding data element can be detected but not corrected. During normal operation, for a read access, the received ECC code word (including both data bits and ECC parity bits) is used by the ECC logic to provide corrected read data (if possible) in response to a read access, and, for a write access, the ECC logic generates a corresponding ECC code word for storing with the write data into array 140. The size needed for each ECC code word is dependent upon the size of the addressable data element being protected by the code word and the type of ECC applied, in which the ECC logic and the generation and storage of ECC code words for the stored data elements of RAM 112 can be implemented as known in the art.

Redundant rows 142 include a set of redundant rows, and redundant cols 144 include a set of redundant cols, in which the redundant rows and cols are structured similar to the rows and columns of array 140. In one embodiment the redundant rows and cols may be considered to be a part of array 140, but are typically located outside of array 140. The set of redundant rows and redundant columns can include any number of rows and columns, respectively. Any known redundancy repair scheme using redundant rows, redundant columns, or both, can be implemented within RAM 112. For example, any row in array 140 may be repaired by replacing that row with a replacement row selected from redundant rows 142. In one embodiment, this is done by accessing the redundant row instead of the replaced row, or by shifting in the data of the replacement row when accessing the replaced row. Further, a single row may be replaced with a single row from redundant rows 142 or multiple rows may be replaced with multiple rows from redundant rows 142. The same is true for columns of array 140 in which any column may be repaired by replacing that column with a replacement column selected from redundant cols 144. Regardless of how the repair is implemented, a row or column of array 140 can be repaired by using a selected row from redundant rows 142 or a selected column from redundant cols 144, respectively.

Therefore, note that ECC correction is a different mechanism from redundancy repair, in which both can be utilized for a particular memory. For example, as used herein, any data corrected by ECC is referred to as "corrected data" while any rows or columns repaired by row or column repair is referred to as "repaired data." That is, correctable data refers to data correctable by ECC in which, in the case of single bit error correction and multi-bit error detection, a data element with a single bit error corresponds to correctable data which includes a correctable error while a data element with a multi-bit error corresponds to uncorrectable data which includes an uncorrectable error. Similarly, if a data element can be repaired with an available redundant row or column, then the data element corresponds to a repairable data element while if the data element cannot be repaired with a redundant row or column, or there are no appropriate redundant rows or columns available, a data element corresponds to an unrepairable data element.

Operation of MBIST controller 110 will be described in reference to details illustrated in block diagram form within MBIST controller 110 of FIG. 1, in which MBIST controller 110 includes a test control circuit 116, a comparator 118, an error counter 120, an uncorrectable error counter 126, a multi-bit fault detection storage circuit 124, a repair control circuit 130, a row repair Built-In Self Repair (BISR) storage circuit 132, and a column repair BISR storage circuit 134. (Each of the BISRs may simply be referred to as repair control circuits.) Test control circuit 116 controls memory testing in one or more RAMs coupled to the MBIST controller (e.g. RAM 112 and 114). This may include performing writes of test data to the one or more RAMs, reads from the one or more RAMs, and comparing the read data to the expected previously written test data. For example, for writing test data, test control circuit 116 communicates write access requests having a corresponding test access address (TEST ADDRESS) and corresponding write test data (WRITE DATA). For each write access, the corresponding write test data corresponds to an addressable data element to be stored into array 140. For reading test data, test control circuit 116 communicates read access requests having a corresponding TEST ADDRESS, and corresponding read test data (READ DATA) retrieved from array 140 is returned to comparator 118 of MBIST controller 110. For each read access, the corresponding read test data corresponds to an addressable data element returned from array 140. Also, since MBIST controller 110 controls testing in more than one memory (e.g. RAM 112 and 114), each memory may have a corresponding identifier, in which test control circuit 116, with each read or write access request, also provides a memory select indicator (MEMORY SELECT) to identify which memory is being accessed.

Note that test control circuit 116 can be implemented using any type of known test circuitry to perform memory testing with any type of test patterns (test address patterns and test data patterns). For example, in one embodiment, test control circuit 116 can be implemented with a finite state machine (FSM), as known in the art. As with many MBIST controllers, though, note that MBIST controller 110 does not include ECC logic to perform ECC detection and correction, as the purpose of the MBIST is to identify defects in bit cell array 140, which precludes hiding defects by correcting single bit errors. However, MBIST controller 110 includes an error counter 120, which has a corresponding error count register (ECR) 122, as well as multi-bit fault detection storage circuit 124, which is configured to store a multi-bit fault detection (EFD) indicator (also referred to as an EFD flag).

In operation, test control circuit 116 sends test write requests to RAM 112 (e.g. to memory control circuit 150) to store test WRITE DATA to array 140, via read/write circuitry 152 and COL MUX 148, as described above. In one embodiment, array 140 is written completely with a predetermined test pattern. After the test data is written to array 140, test control circuit 116 sends a test read request to RAM 112 (e.g. to memory control circuit 150) in which READ DATA from array 140 is returned by read/write circuitry 152 to comparator 118. Comparator 118 compares this READ DATA to EXPECTED DATA provided by test control circuit 116. The EXPECTED DATA corresponds, for example, to a portion of the predetermined test pattern previously written to array 140. In one embodiment, comparator 118 is a bit-wise comparator which compares each bit of the READ DATA to a corresponding bit of the EXPECTED DATA. If there is a mismatch, indicating an error at the corresponding address location of array 140 (indicated by the corresponding access address of the test read request), error counter 120 increments the error count value in ECR 122. Note that the error count value in ECR 122 is incremented by one regardless if the error is a single bit error or multi-bit error. If comparator 118 determines that more than one bit mismatched, the EFD flag is asserted (e.g. to a logic level one) to indicate occurrence of a multi-bit error. Also, in this case, uncorrectable error counter 126 increments, and an uncorrectable error count value is stored in uncorrectable error count register (UECR) 128. That is, any error which would result in asserting the EFD flag increases the uncorrectable error count value, in which a detected multi-bit error increases the uncorrectable error count value by one, regardless of how many individual bit errors are in the detected multi-bit error. Note that the uncorrectable error count value is only incremented in response to detection of an uncorrectable error count once per access address.

After the READ DATA is compared with EXPECTED DATA, the results are provided to repair control circuit 130 which determines, based on the mismatched bits, if any, whether to apply column repair or row repair. If column pair is applied to fix a bit error, then the information for which column of array 140 to repair (e.g. replace) with which redundant column of redundant cols 144 is stored in column repair BISR 134. Similarly, if row repair is applied to fix the bit error or bit errors, then the information for which row of array 140 to repair (e.g. replace) with which redundant row of redundant rows 142 is stored in row repair BISR 132. This information is given to memory control circuit 150 which uses the information to make sure that, in response to an access address (whether during normal operation or test), the correct row or column is accessed (using a redundant row or column when needed) when performing a read from or write to array 140.

Therefore, when memory testing is done during production, a repair control circuit can determine to implement row or column repair (or both) and configure the BISRs as needed prior to shipping an SoC. If errors found during testing cannot be repaired with column or row repair mechanisms, that device (e.g. that SoC) can be discarded and not shipped or sold to customers. There are cases, though, in which, due to errors found during production testing, a decision to discard the device may make sense, even if column or row repair could be used. As illustrated in FIG. 1, counters can be used to provide more information during production memory testing to help evaluate whether or not to discard a part. For example, ECR 122 keeps track of errors during MBIST runs during production testing, while UECR 128 further keeps track of multi-bit errors during MBIST runs during production testing. That is, while ECC may or may not be available within MBIST controller 110, EFD flag 124 at least determines if a multi-bit error has occurred and UECR 128 keeps track of how many multi-bit errors has occurred. This information can be used to further provide information as a result of production memory testing.

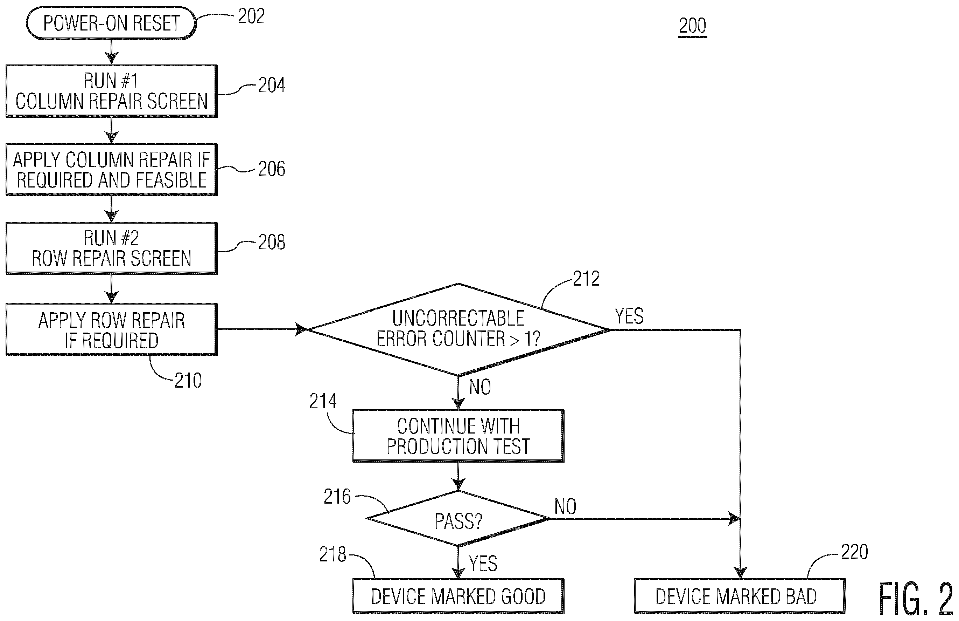

FIG. 2 illustrates, in flow diagram form, a method 200 for performing production memory testing, in accordance with one embodiment of the present invention. Production testing typically occurs during production of a memory or SoC, prior to shipping the part or device to a customer. Therefore, method 200 represents a production test performed on a memory (e.g. RAM 112 or 114) whose testing is controlled by an MBIST controller (e.g. MBIST controller 110). Method 200 will be described in reference to MBIST controller 110 and RAM 112 as an example. Memory testing begins in block 202 with a power-on reset (POR), in which the count values of ECR 122 and UECR 128, as well as EFD flag 124, are reset (e.g. cleared) in response to the POR. MBIST controller 110 then completes a first run (run #1) corresponding to a column repair screen (in which column repair but not row repair is enabled as a repair option). A memory testing run (referred to simply as a "run") refers to a set of writes which writes test data (e.g. a test data pattern), reads test data, and performs comparisons, as controlled by test control circuit 116) on the memories tested by MBIST controller 110. Therefore, in the illustrated embodiment, a run may include performing a write of a test data pattern to a portion or all of array 140 of RAM 112, and then performing reads of the test data and comparisons with the expected data. Also, if there are multiple memories, such as in FIG. 1, a single run may include performing the writes, reads, and compares within each of RAM 112 and RAM 114. In this case, the count values will remain counting during the runs which goes through both RAM 112 and 114. Note that each run can be designed to use any test data, test pattern, etc., as known in the art.

The first run of block 204 corresponds to a column repair screen in which it is determined whether a column repair can be used for an error found during the run. In one embodiment, if multiple errors are found, column repair is applied to the first error found, with respect to time, during the first run. In block 206, column repair is applied to a bit error if required (i.e. if a bit error was found) and if feasible (e.g. if the bit error is repairable by a column repair). Applying column repair may include configuring or updating column repair BISR 134 with the appropriate information for the repair.

Next, in block 208, a second run (run #2) is performed corresponding to a row repair screen (in which row repair but not column repair is enabled as a repair option). For this second run, the column repair, if any, from the first run is applied during the testing. In one embodiment, the count values of ECR 122 and UECR 128, as well as EFD flag 124, are reset (e.g. cleared) prior to each run (or, alternatively, just the count value of UECR 128 is reset). For the second run, it is determined whether a row repair can be used for an error found during the run. In one embodiment, a row repair can be applied to a single bit error or to multiple bit errors. A row repair can also be applied to a partial or a full row. Therefore, in block 210, row repair is applied to one or more bit errors if required (i.e. if one or more bit errors were found) and if feasible (if the one or more bit errors are repairable by a row repair). Applying row repair may include configuring or updating row repair BISR 132 with the appropriate information for the repair.

Next, at decision diamond 212, it is determined if the count value of UECR 128 is greater than a predetermined threshold. This threshold may be used to set a particular number of uncorrectable errors that would be acceptable or allowable for shipping a part. In one embodiment, this threshold value is one, such that zero or one remaining uncorrectable errors may be acceptable, while anything more than one may not be deemed acceptable. Therefore, if the count value is greater than one, at block 220, the device (e.g. SoC) is marked as bad and can be discarded. If the counter value is not greater than one, then, at block 214, production testing can continue (as known in the art, with any other required production testing). If, at decision diamond 216, the device passes, then the device can be marked as good at block 218 (in which the device can, e.g., be shipped or sold). If the device does not pass, it is marked as bad at block 220.

FIGs. 3-6 provide various examples of different scenarios in which UECR 128 may be used to provide additional information which can be used to identify situations in which a device may need to be discarded. Each of these figures illustrates a physical bit cell topology of array 140 of RAM 112 and a corresponding logical memory view 300 of array 140. In the examples of FIGs. 3-6, it is assumed that array 140 is a 16x16 bit cell array, in which each box in the illustrated examples represents one bit. Therefore, as illustrated, for example, in FIG. 3, the bit cell topology of array 140 includes 16 rows (row # 0 -- row # 15) of 16 bits each. Array 140 is organized logically (as illustrated in logical memory view 300) as a 64x4 bit memory. That is, each row of the 64 rows corresponds to an addressable data element of 4 bits (i.e. a nibble) such that each access address to array 140 addresses a particular 4-bit nibble at that address location. Therefore, for each read access to array 140, a 4-bit stored data element is accessed from an addressed location of array 140 and returned as D0-D3. Similarly, for each write access to array 140, a 4-bit data element is provided as D0-D3 to be stored in an addressed location of array 140.

In the illustrated embodiment, it is assumed that the physical bit cell topology includes a column MUX implementation of 4. That is, array 140 is implemented as having 4 sets of columns, each set of columns including 4 columns (as illustrated by the alternating sets of 4 white columns and 4 shaded columns). COL MUX 148, using a two-bit col select signal (COL SEL[1:0]), couples one column of each set of columns to a corresponding data line (of DL0- DL3) which is coupled to read/write circuitry 152. For example, each column of the first set of columns of array 140 (going from left to right) is coupled to a 4-to-1 MUX of COL MUX 148 which selects one of the first set of columns to couple to DL0. If COL SEL[1:0] = %00, the first column (from left to right) of the first set of columns is coupled to DL0, if COL SEL[1:0] = %01, the second column (from left to right) of the first set of columns is coupled to DL0, etc. (As used herein, a "%" preceding a value indicates the value is in binary form.) Similarly, each column of the second set of columns of array 140 (going from left to right) is coupled to a 4-to-1 MUX of COL MUX 148 which selects one of the second set of columns to couple to DL1. If COL SEL[1:0] = %00, the first column (from left to right) of the second set of columns is coupled to DL1, if COL SEL[1:0] = %01, the second column (from left to right) of the second set of columns is coupled to DL1, etc. Therefore, for each access, one column of each of the 4 sets of columns is coupled to a corresponding data line.

In one example, COL SEL[1:0] corresponds to the two lower order bits of the access address for a location. Therefore, for each read or write access to array 140, one of rows 0-15 is selected, and one column of each set of columns is accessed to read or write a nibble of data. For a read access, read/write circuitry 152 senses the DL0-DL3 to provide D0 - D3 as the READ DATA. For a write access, read/write circuitry 152 provides D0-D3 to DL0-DL3 to properly store the write data to the addressed location.

Therefore, each row of the physical topology stores 4 addressable nibbles, in which each column of 4-bits stores one bit of each nibble. For example, row #0 includes 4 sets of columns of 4 bits each. As illustrated in corresponding logical memory view 300, ADDR 0 addresses a first nibble of row #0, ADDR 1 addresses a second nibble of row #0, ADDR 2 a third nibble, and ADDR 3 a fourth nibble. The first nibble at ADDR 0 is accessed when row #0 is activated and COL SEL[1:0] = %00 (as labeled to the right of the array in logical memory view 300). The second nibble at ADDR 1 is accessed when row #0 is activated and COL SEL[1:0] = %01, etc. As another example, row #3 similarly includes 4 set of columns of 4 bits each. As illustrated in corresponding logical memory view 300, ADDR 12 addresses a first nibble of row #3 (accessed with COL SEL[1:0] = %00), ADDR 13 a second nibble (accessed with COL SEL[1:0] = %01), ADDR 14 a third nibble (accessed with COL SEL[1:0] = %10), and ADDR 14 a fourth nibble (accessed with COL SEL[1:0] = %11).

Note that the column MUXing and addressing, and thus the implementation of COL MUX 148 and read/write circuitry 152, are known in the art and can be implemented in any known manner. Similarly, column MUXing may not be used in which the physical bit cell topology can include the same number of columns as the accessed data elements. The accessed data elements, although illustrated as a nibble, can be any size data elements (e.g. byte, word, double-word, etc.). Therefore, the logical memory view for the physical bit cell topology may also differ, depending on the embodiment.

Note also that in alternate embodiments, only one of row or column repair is applied during the production test. For example, in an alternate embodiment, only a run with a row repair screen is performed during which the count value of UECR 128 is updated. In this case, only row repair may be available for the memory but not column repair. Alternatively, only a run with a column repair screen is performed during which the count value of UECR 128 is updated. In this case, only col repair may be available for the memory but not row repair. Therefore, note that, as used herein, "row/column repair" may include both row repair and column repair, in which a run is performed enabling each or may include only one of row or column repair. In the latter case, in one embodiment, only one run is performed to obtain the count value of UECR 128.

FIG. 3 illustrates an example in which array 140 has two single bit faults, and the two bit faults are unrelated (not in the same row of array 140 nor the same column of array 140). For the illustrated example, it is assumed that a first bit 302 (which is illustrated by the bolded box having a "1" inside) is a faulty bit and a second bit 304 (illustrated by the bolded box having a "2" inside) is a faulty bit. As illustrated in corresponding logical memory view 300, bits 302 and 304 occur in different addressable nibbles (the nibble at ADDR 3 and the nibble at ADDR 14, respectively). Referring to method 200 of FIG. 2, after run #1, both errors of bit 302 and 304 are found. Therefore, the count value of ECR 122 is two and the count value of UECR 128 is zero since neither bit error corresponds to a multi-bit error in an addressable data element (i.e. addressable nibble). In this case, one of the faults can be repaired by column repair, and since it is assumed that bit 302 was found first in time, column repair BISR 134 is updated to repair bit 302 (this may involve, for example, replacing the column which contains bit 302 with a column from redundant cols 144). With this column repair, run #2 is performed, and the error of bit 304 is found again. (Note that error of bit 302 has already been repaired with a column repair and therefore is not found again during run #2.) Therefore, the count value of ECR 122 is now one and the count value of UECR 128 remains at zero. In this case, row repair BISR 132 is updated to repair bit 304 (this may involve replacing all or a portion of row #3). Since, at decision diamond 212, the count value of UECR 128 is zero, it can be shipped (configured with the col and row repair for bits 302 and 304).

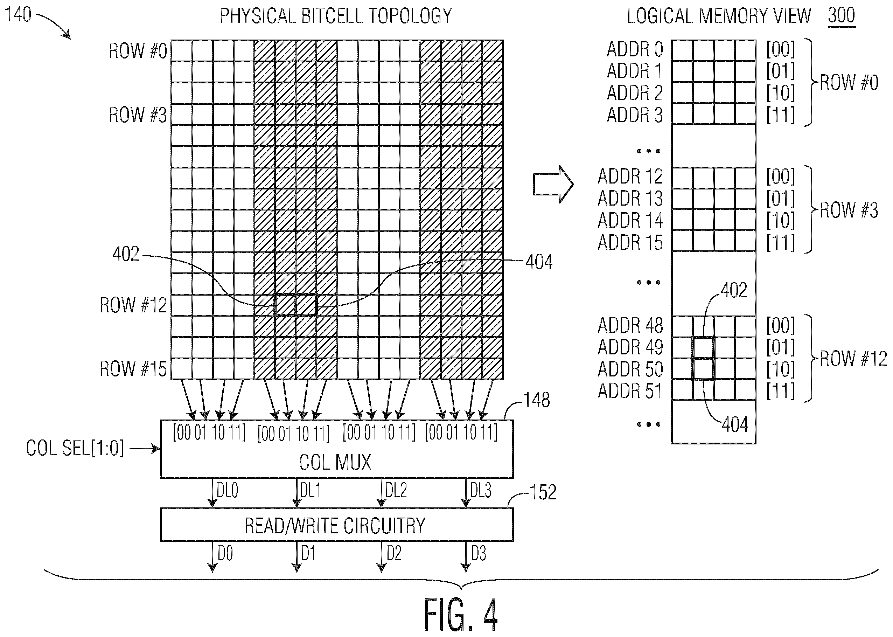

FIG. 4 illustrates an example in which array 140 has two single bit faults, however, the two faults are in the same row of array 140 but in different addressable nibbles. For the illustrated example, it is assumed that a first bit 402 is a faulty bit and a second bit 404 is a faulty bit (both illustrated by a bolded box). These bits are located directly adjacent each other in row #12 of the physical bit cell topology, and, as illustrated in corresponding logical memory view 300, they are located in different addressable nibbles (one at ADDR 49 and the other at ADDR 50, respectively). In this case, since they are located in a same row, they can be repaired by a single row repair for row #12. For this example, the resulting count value for UECR 128 would also be zero as the two bit errors do not result in a multi-bit error of an addressable nibble.

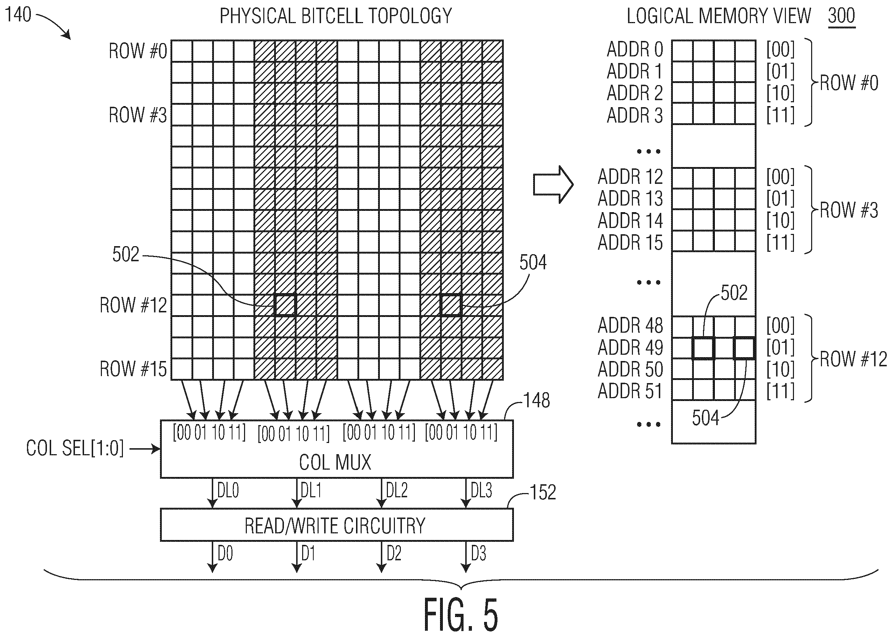

FIG. 5 illustrates an example in which array 140 has two single bit faults, however, the two faults are in the same row of array 140 and in a same addressable nibble. For the illustrated example, it is assumed that a first bit 502 is a faulty bit and a second bit 504 is a faulty bit (both illustrated by a bolded box). These bits are both located in row #12 of the physical bit cell topology, and, as illustrated in corresponding logical memory view 300, they are located in the same addressable nibble (at ADDR 49) in which each of bits 502 and 504 are in the second column of their corresponding set of columns (i.e. COL SEL[1:0] for both corresponds to %01). In this case, since they are located in a same row, they can be both repaired by a single row repair of row #12. For this example, the resulting count value for UECR 128 would only be one since it is the only addressable nibble with a multi-bit error. This is an acceptable level for the count value in UECR 128 (it is not greater than one), therefore, the two bit faults are acceptable.

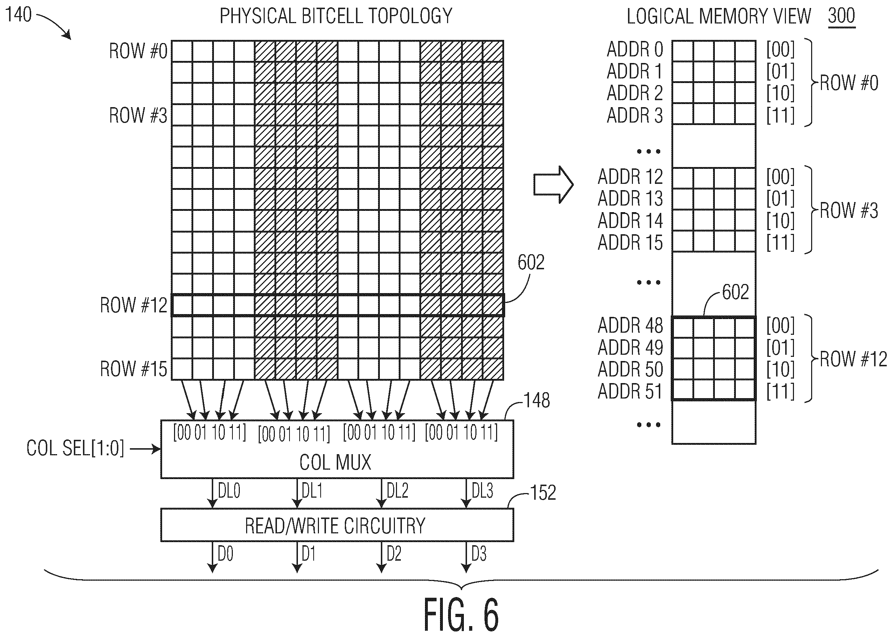

FIG. 6 illustrates an example in which array 140 has multiple single bit faults, all along a same row, row #12, of array 140. For the illustrated example, it is assumed that all the bits 602 in row #12 are faulty bits (as illustrated by a bolded box). As illustrated in corresponding logical memory view 300, this results in a cluster of multi-bit errors in each of the addressable nibbles at ADDR 48, ADDR 49, ADDR 50, and ADDR 51. In this case, since they are located in a same row, they can be repaired by a full row repair of row #12. However, when there are too many faulty bits clustered in a same physical row, there may be an increased risk for additional bit failures in the lifetime of the device. For this example, the resulting count value for UECR 128 would be four as four addressable nibbles have a multi-bit error. As illustrated with method 200 in FIG. 2, this is greater than the acceptable level for the count value in UECR 128. Therefore, even though the entire row may be repairable by a row repair, it may still be desirable to discard the part as a bad part due to the increased danger of latent failure indicated by the high count value of UECR 128.

Therefore, it can be seen that even if array 140 has bit faults which are all correctable by a combination of available row and column repairs, the count value of UECR 128 can be used to determine whether a part should be discarded regardless. That is, UECR 128 gives extra visibility into the results of memory testing for RAM 112 beyond ECR 122 and EFD flag 124. Note also that if array 140, when tested, has more bit faults that can be handled by a combination of available row and column repairs, the device may be indicated as bad regardless of the count values of UEC 122 and UECR 128. Therefore, by now it can be appreciated how the use of a multi-bit or uncorrectable error counter can be used, in place of or in addition to a multi-bit error detection flag and an error counter, to provide further insight into errors during production testing. This insight may be used to better determine how to discard devices to achieve a desired balance between repair and yield.

An integrated circuit includes a memory having an array and a memory built-in self test (MBIST) controller. The MBIST controller is configured to perform memory testing rungs on the memory and includes a first counter and a repair control circuit. The first counter is configured to count uncorrectable errors during each memory testing run. The repair control circuit is configured to, in response to an error found during a memory testing run, determine whether at least one of row repair or column repair can be applied to repair the error.

The terms "assert" or "set" and "negate" (or "deassert" or "clear") are used herein when referring to the rendering of a signal, status bit, or similar apparatus into its logically true or logically false state, respectively. If the logically true state is a logic level one, the logically false state is a logic level zero. And if the logically true state is a logic level zero, the logically false state is a logic level one.

Each signal described herein may be designed as positive or negative logic, where negative logic can be indicated by a bar over the signal name or an asterisk (*) following the name. In the case of a negative logic signal, the signal is active low where the logically true state corresponds to a logic level zero. In the case of a positive logic signal, the signal is active high where the logically true state corresponds to a logic level one. Note that any of the signals described herein can be designed as either negative or positive logic signals. Therefore, in alternate embodiments, those signals described as positive logic signals may be implemented as negative logic signals, and those signals described as negative logic signals may be implemented as positive logic signals.

Brackets are used herein to indicate the conductors of a bus or the bit locations of a value. For example, "value[7:0]" or "value[0:7]" indicates eight bit values of the value. The symbol "$" preceding a number indicates that the number is represented in its hexadecimal or base sixteen form. The symbol "%" preceding a number indicates that the number is represented in its binary or base two form.

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

Although the invention has been described with respect to specific conductivity types or polarity of potentials, skilled artisans appreciated that conductivity types and polarities of potentials may be reversed.

Moreover, the terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Some of the above embodiments, as applicable, may be implemented using a variety of different information processing systems. For example, although FIG. 1 and the discussion thereof describe an exemplary information processing architecture, this exemplary architecture is presented merely to provide a useful reference in discussing various aspects of the invention. Of course, the description of the architecture has been simplified for purposes of discussion, and it is just one of many different types of appropriate architectures that may be used in accordance with the invention. Those skilled in the art will recognize that the boundaries between logic blocks are merely illustrative and that alternative embodiments may merge logic blocks or circuit elements or impose an alternate decomposition of functionality upon various logic blocks or circuit elements. Thus, it is to be understood that the architectures depicted herein are merely exemplary, and that in fact many other architectures can be implemented which achieve the same functionality.

Also for example, in one embodiment, the illustrated elements of system 100 are circuitry located on a single integrated circuit or within a same device (such as an SoC). Alternatively, system 10 may include any number of separate integrated circuits or separate devices interconnected with each other.

Furthermore, those skilled in the art will recognize that boundaries between the functionality of the above described operations merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

Although the invention is described herein with reference to specific embodiments, various modifications and changes can be made without departing from the scope of the present invention as set forth in the claims below. For example, any of the counters described herein within MIBST controller 110 can be implemented to count by either incrementing (increasing the corresponding count value) or decrementing (decreasing the corresponding count value), depending on the implementation. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

The term "coupled," as used herein, is not intended to be limited to a direct coupling or a mechanical coupling.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

The following are various embodiments of the present invention. Note that any of the aspects below can be used in any combination with each other and with any of the disclosed embodiments.

In an embodiment, an integrated circuit includes a memory having an array; and a memory BIST (MBIST) controller, the MBIST controller configured to perform memory testing runs on the memory. The MBIST controller has a first counter configured to count uncorrectable errors during each memory testing run; and a repair control circuit configured to, in response to an error found during a memory testing run, determine whether at least one of row repair or column repair can be applied to repair the error. In one aspect, each counted uncorrectable error corresponds to a multi-bit error detected within an accessed data element returned to the MBIST controller as read test data from the array. In a further aspect, the MBIST controller further includes a multi-bit fault detection flag, wherein the MBIST controller is configured to assert the multi-bit fault detection flag in response to occurrence of at least one multi-bit error. In yet a further aspect, the MBIST controller further includes a second counter configured to count errors found within accessed data elements returned to the MBIST controller as read data from the array during each memory testing run, wherein each counted error by the second counter may correspond to either a single bit error in a corresponding accessed data element or a multi-bit error in the corresponding accessed data element. In another aspect of the above embodiment, each memory testing run includes a set of writes to write corresponding test data to the array, a set of reads to obtain corresponding read data from the array, and comparisons between the obtained read data and expected read data to detect occurrence of any bit errors. In a further aspect, when multiple bit errors are detected within read test data returned in response to a same access address of read access request, the MBIST controller is configured to update the first counter to count the multiple bit errors as an uncorrectable error. In yet a further aspect, the MBIST controller is configured to only update the first counter once for any multiple bit error corresponding to the same access address. In another further aspect, the repair control circuit is configured to, upon completion of a first memory testing run, determine whether a row/column repair can be applied to repair a first detected bit error. In a further aspect, the repair control circuit is configured to, in response to determining that row/column repair can be applied to repair the first detected bit error, configure a repair control register for the first detected bit error. In yet a further aspect, for a second memory testing run, the MBIST controller is configured to reset the first counter such that, during the second memory testing run, the repair is applied to the first detected bit error, and upon completion of the second memory testing run, the repair control circuit is configured to determine whether row/column repair can be applied to repair a second detected bit error which is in a different location of the array as the first detected bit error. In yet an even further aspect, the repair control circuit is configured to apply row repair for the first detected bit error and apply column repair to the second detected bit error. In another aspect of the above embodiment, after completion of a set of memory testing runs, the memory is identified as a bad part in response to the count of uncorrectable errors in the first counter being greater than a predetermined threshold. In another aspect, the integrated circuit further includes a plurality of memories, wherein, for each memory testing run, the MBIST controller is configured to perform the memory testing run on all memories of the plurality of memories. In a further aspect, the MBIST controller is configured to reset the first counter prior to each memory testing run, such that, after completion of each memory testing run, the first counter is configured to provide the count of uncorrectable errors which collectively occurred in all the memories of the plurality of memories during the memory testing run.

In another embodiment, an integrated circuit includes a memory having an array; and a memory BIST (MBIST) controller. The MBIST controller is configured to perform memory testing runs on the memory, each memory testing run including a set of writes to write corresponding test data to the array, a set of reads to obtain corresponding read data from the array, and comparisons between the obtained read data and expected read data to detect occurrences of any hit errors. The MBIST controller has a row repair control register, a column repair control register, and a first counter configured to count uncorrectable errors during each memory testing run. The MBIST controller is configured to, upon completion of a first memory testing run, configure the column repair control register to apply column repair to repair a first detected bit error; reset the first counter prior to commencing a second memory testing run, the second memory testing run is performed while applying column repair to repair the first detected bit error; and, upon completion of a second memory testing run, configure the row repair control register to apply row repair to repair a second detected bit error. In a further aspect, when multiple bit errors are detected within an accessed data element returned as read test data from an access address of the array, the MBIST controller is configured to update the first counter to count the multiple bit errors as a detected uncorrectable error. In a further aspect, the MBIST controller further includes a multi-bit fault detection flag, wherein the MBIST controller is configured to assert the multi-bit fault detection flag in response to occurrence of at least one multi-bit error. In another aspect, the MBIST controller is configured to only update the first counter once for any multiple bit error corresponding to the same access address. In another aspect, after completion of a set of memory testing runs, the memory is identified as a bad part in response to the count of uncorrectable errors in the first counter being greater than a predetermined threshold. In yet another aspect of the another embodiment, the memory further includes a set of redundant columns and a set of redundant rows, and the MBIST controller further includes a repair control circuit configured to configure the column and row repair control registers, when the repair control register is configured for the row repair, apply the row repair during a memory testing run, and when the column control register is configured for the column repair, apply the column repair during the memory testing run.

## Claims

1. An integrated circuit, comprising:
a memory having an array; and
a memory BIST (MBIST) controller, the MBIST controller configured to perform memory testing runs on the memory, the MBIST controller having:
a first counter configured to count uncorrectable errors during each memory testing run; and
a repair control circuit configured to, in response to an error found during a memory testing run, determine whether at least one of row repair or column repair can be applied to repair the error.

2. The integrated circuit of claim 1, wherein each counted uncorrectable error corresponds to a multi-bit error detected within an accessed data element returned to the MBIST controller as read test data from the array.

3. The integrated circuit of claim 2, wherein the MBIST controller further comprises a multi-bit fault detection flag, wherein the MBIST controller is configured to assert the multi-bit fault detection flag in response to occurrence of at least one multi-bit error.

4. The integrated circuit of claim 3, wherein the MBIST controller further comprises:
a second counter configured to count errors found within accessed data elements returned to the MBIST controller as read data from the array during each memory testing run, wherein each counted error by the second counter may correspond to either a single bit error in a corresponding accessed data element or a multi-bit error in the corresponding accessed data element.

5. The integrated circuit of any preceding claim, wherein each memory testing run comprises a set of writes to write corresponding test data to the array, a set of reads to obtain corresponding read data from the array, and comparisons between the obtained read data and expected read data to detect occurrence of any bit errors.

6. The integrated circuit of claim 5, wherein when multiple bit errors are detected within read test data returned in response to a same access address of read access request, the MBIST controller is configured to update the first counter to count the multiple bit errors as an uncorrectable error.

7. The integrated circuit of claim 6, wherein the MBIST controller is configured to only update the first counter once for any multiple bit error corresponding to the same access address.

8. The integrated circuit of any of claims 5 to 7, wherein the repair control circuit is configured to, upon completion of a first memory testing run, determine whether a row/column repair can be applied to repair a first detected bit error.

9. The integrated circuit of claim 8, wherein, the repair control circuit is configured to, in response to determining that row/column repair can be applied to repair the first detected bit error, configure a repair control register for the first detected bit error.

10. The integrated circuit of claim 9, wherein:
for a second memory testing run, the MBIST controller is configured to reset the first counter such that, during the second memory testing run, the repair is applied to the first detected bit error, and
upon completion of the second memory testing run, the repair control circuit is configured to determine whether row/column repair can be applied to repair a second detected bit error which is in a different location of the array as the first detected bit error.

11. The integrated circuit of claim 10, wherein the repair control circuit is configured to apply row repair for the first detected bit error and apply column repair to the second detected bit error.

12. The integrated circuit of any preceding claim, wherein, after completion of a set of memory testing runs, the memory is identified as a bad part in response to the count of uncorrectable errors in the first counter being greater than a predetermined threshold.

13. The integrated circuit of any preceding claim, further comprising a plurality of memories, wherein, for each memory testing run, the MBIST controller is configured to perform the memory testing run on all memories of the plurality of memories.

14. The integrated circuit of claim 13, wherein the MBIST controller is configured to reset the first counter prior to each memory testing run, such that, after completion of each memory testing run, the first counter is configured to provide the count of uncorrectable errors which collectively occurred in all the memories of the plurality of memories during the memory testing run.
